(19) **Europäisches Patentamt**
**European Patent Office**
**Office européen des brevets**

(11) **EP 1 848 110 A2**

(12) **EUROPEAN PATENT APPLICATION**

(43) Date of publication:
**24.10.2007 Bulletin 2007/43**

(51) Int Cl.:
**H03G 5/16** (2006.01)

(21) Application number: **07106073.5**

(22) Date of filing: **12.04.2007**

(84) Designated Contracting States:
**AT BE BG CH CY CZ DE DK EE ES FI FR GB GR HU IE IS IT LI LT LU LV MC MT NL PL PT RO SE SI SK TR**
Designated Extension States:
**AL BA HR MK YU**

(30) Priority: **17.04.2006 JP 2006112936**

(71) Applicant: **Sony Corporation**
**Minato-ku**
**Tokyo (JP)**

(72) Inventors:
• **Kino, Yasuyuki**
  **Tokyo (JP)**
• **Sawashi, Tokihiko**
  **Tokyo (JP)**

(74) Representative: **Melzer, Wolfgang**
**Mitscherlich & Partner**
**Patent- und Rechtsanwälte**
**Postfach 33 06 09**
**80066 München (DE)**

(54) **Audio output device and method for calculating parameters**

(57)     Disclosed herein is an audio output device including: an equalizer configured to execute frequency characteristic correction processing for an audio signal from an audio source; an output part configured to supply an audio signal processed by the equalizer to a speaker for audio output from the speaker; a signal analyzer configured to analyze a frequency characteristic of an input audio signal to thereby obtain a gain of each of sample points on a frequency axis; and an arithmetic unit configured to control parameters of the equalizer, the arithmetic unit extracting sample points having substantially equal intervals on a logarithmic-scale frequency axis from sample points of which gains have been obtained by the signal analyzer, the arithmetic unit calculating parameters of the equalizer by using differences between gains of the extracted sample points and gains at frequencies corresponding to the extracted sample points on a target frequency characteristic.

# FIG. 1

**Description**

CROSS REFERENCES TO RELATED APPLICATIONS

The present invention contains subject matter related to Japanese Patent Application JP 2006-112936 filed in the Japan Patent Office on April 17, 2006, the entire contents of which being incorporated herein by reference.

BACKGROUND OF THE INVENTION

1. Field of the Invention

The present invention relates to an audio output device that includes an equalizer for correcting a frequency characteristic, and to a method for calculating parameters of an equalizer.

2. Description of the Related Art

As existing general schemes for correcting a transfer characteristic from a measured frequency characteristic to a target frequency characteristic, the following correction schemes are available: (1) a correction scheme employing an FIR filter based on impulse response measurement, (2) a correction scheme employing a graphic equalizer based on gain characteristic measurement (or impulse response measurement), and (3) a correction scheme employing a parametric equalizer based on gain characteristic measurement (or impulse response measurement).
Techniques for automatically correcting a sound field by using a parametric equalizer in a vehicle audio apparatus or home audio apparatus are disclosed in Japanese Patent Laid-open No. 2004-297732 and No. 2001-224100.
Furthermore, techniques relating to calculation of parameters of a parametric equalizer in sound field correction are disclosed in Japanese Patent Laid-Open No. 2001-217665, No. Sho 60-51014, and No. 2000-216664, and Japanese Patent No. 3102796.

SUMMARY OF THE INVENTION

In the scheme (1), very advanced measurement is necessary because impulse response needs to be obtained, and the processing amount and memory amount of a filter for correcting the impulse response are very large (because the filter is an FIR filter). Therefore, the scheme (1) is unsuitable for the situation where resources for the correction processing are limited and the situation where advanced measurement may be impossible.
In the scheme (2), a large number of bands (equalizers) are requisite for fine characteristic correction, and hence both the processing amount and memory amount in the characteristic correction tend to be large. Therefore, the scheme (2) is also unsuitable in many cases.
In contrast, in the scheme (3), the center frequency, gain, and sharpness (Q value) are variable for each band (band of frequency characteristic correction processing). Therefore, fine characteristic correction with a small number of bands is permitted. Consequently, the correction processing can be executed with very small memory amount and processing amount.
However, an existing method of the scheme (3) involves the following problem. Specifically, in processing for determining parameters (center frequency, gain, and sharpness (Q value)) of a parametric equalizer, the processing burden and memory burden for calculation of the parameters are very heavy because (floating) decimal point arithmetic and complex arithmetic with the trigonometric function are used, and a table with a very large size is necessary for the calculation. The kind of hardware that can execute such arithmetic is limited.
There is a need for the present invention to make an improvement to the process of calculating parameters for frequency characteristic correction by a parametric equalizer, to thereby allow the parameter calculation through simple arithmetic operation.
According to an embodiment of the present invention, there is provided an audio output device. The device includes an equalizer configured to execute frequency characteristic correction processing for an audio signal from an audio source, an output part configured to supply an audio signal processed by the equalizer to a speaker for audio output from the speaker, and a signal analyzer configured to analyze the frequency characteristic of an input audio signal to thereby obtain the gain of each of sample points on a frequency axis. The device includes also an arithmetic unit configured to control parameters of the equalizer. The arithmetic unit extracts sample points having substantially equal intervals on a logarithmic-scale frequency axis (logarithmic axis, the logarithmic-scale will be referred to also as a Log-scale) from the sample points of which gains have been obtained by the signal analyzer. The arithmetic unit calculates the parameters of the equalizer by using differences between the gains of the extracted sample points and the gains at frequencies corresponding to the extracted sample points on a target frequency characteristic.

According to another embodiment of the present invention, there is provided a method for calculating parameters of an equalizer for correcting the frequency characteristic of an audio signal to a target frequency characteristic. The method includes the steps of (a) analyzing the frequency characteristic of an input audio signal to thereby obtain the gain of each of sample points on a frequency axis, and (b) extracting sample points having substantially equal intervals on a logarithmic-scale frequency axis from the sample points of which gains have been obtained in the step (a), and calculating the parameters of the equalizer by using differences between the gains of the extracted sample points and the gains at frequencies corresponding to the extracted sample points on the target frequency characteristic.

The embodiments of the present invention relate to an audio output device in which frequency characteristic analysis is carried out for a measurement signal (signal to be measured) collected through a microphone and encompassing the transfer characteristic of the space, and an equalizer corrects the frequency characteristic of an audio signal output from a speaker (audio signal to reach the position of the microphone from the speaker) depending on the analysis result so that the frequency characteristic may be brought close to a target frequency characteristic. In particular, the embodiments can employ improvements relating to the way of holding gain sequences as equalizer characteristics and the arithmetic method for determining proper parameters. This allows the optimum equalizer parameters for the correcting to the target frequency characteristic to be calculated only through very simple arithmetic operation (i.e., integer-type sum-of-products operation).

As the improvement in the arithmetic method, sample points having substantially equal intervals on a logarithmic-scale frequency axis are used in parameter calculation. Through frequency analysis of a measurement audio signal, the gains of sample points having equal intervals on a linear scale are obtained. If the interval between the sample points is 20 Hz, e.g. the frequency points at frequencies 20 Hz, 40 Hz, 60 Hz, 80 Hz, 100 Hz, 120 Hz, ⋯ are employed as the sample points. Of these sample points having equal intervals on the linear scale, sample points having substantially equal intervals on a Log scale are extracted. For example, the sample points at frequencies 100 Hz, 200 Hz, 400 Hz, 800 Hz, 1.6 kHz, ⋯ are extracted. As is apparent from this example, the term "sample points having substantially equal intervals on a logarithmic scale" refers to frequency points that are represented at positions having substantially equal intervals when being plotted on the logarithmic scale.

In selection of sharpness (Q value) for bringing a measured frequency characteristic close to a target frequency characteristic, the Q value that offers a small difference area between the measured frequency characteristic and the target frequency characteristic is selected. Because the sample points have substantially equal intervals on a logarithmic scale, the value equivalent to the difference area can be obtained as the sum of the differences in the gain between the respective sample points and the corresponding frequency points on the target frequency characteristic.

The expression "substantially equal intervals on a logarithmic scale" means that the sample points do not necessarily need to have exactly equal intervals, but substantially equal intervals are permitted. It should be obvious that exactly equal intervals are preferable. However, substantially equal intervals are also available as long as no problem arises in the scheme in which a value equivalent to a difference area for a Q-value candidate is obtained as the sum of the differences in the gain between the respective sample points having the substantially equal intervals on a logarithmic-scale frequency axis and the corresponding frequency points on the target frequency characteristic.

Furthermore, a gain sequence corresponding to the same sharpness (Q value) and gain as a correction characteristic of a parametric equalizer shows the same characteristic curve, when being plotted on a logarithmic scale, irrespective of the center frequency.

In addition, a correction characteristic of a parametric equalizer is symmetric on a logarithmic scale.

Furthermore, frequency points having equal intervals on a logarithmic scale can be employed as the respective points of a gain sequence as a correction characteristic.

According to embodiments of the present invention, sample points having substantially equal intervals on a logarithmic-scale frequency axis are extracted from the respective sample points of which gains have been found through frequency analysis. Subsequently, parameters of an equalizer are calculated by using the differences in the gain between the extracted sample points and the frequency points corresponding to the extracted sample points on a target frequency characteristic. In particular, of the frequencies of the sample points having substantially equal intervals on a logarithmic-scale frequency axis, the frequency of the sample point offering the largest gain difference with respect to the target frequency characteristic is defined as the center frequency. Furthermore, the gain difference between the sample point defined as the point of the center frequency and the corresponding frequency point on the target frequency characteristic is defined as the gain as a parameter. Subsequently, difference areas between the target frequency characteristic and corrected frequency characteristics each corresponding to the determined center frequency and gain, and a respective one of plural sharpness candidates are calculated, and the sharpness offering the smallest difference area is defined as the sharpness as a parameter. The difference area for the sharpness determination is obtained as the sum of the differences in the gain between the respective sample points having subsequently equal intervals on a logarithmic-scale frequency axis and the corresponding frequency points on the target frequency characteristic.

This scheme offers an advantage that the parameters of a parametric equalizer for multiband can be calculated only through addition and subtraction of integer-type variables. This calculation can be executed even by a low-speed and low-function arithmetic unit (e.g. a cheap microcomputer or digital signal processor (DSP)), and hence can be easily employed in various audio output devices at low costs.

A correction characteristic table holds gain sequences as equalizer correction characteristics corresponding to combinations of a center frequency, gain, and sharpness. A correction characteristic of a parametric equalizer shows the same curve on a logarithmic scale irrespective of the center frequency, and is symmetric on a logarithmic scale. Furthermore, frequency points having equal intervals on a logarithmic scale can be employed as the respective points of a gain sequence as a correction characteristic. Therefore, gain sequences corresponding to various combinations of a center frequency, gain, and sharpness can be obtained through simple arithmetic operation on a certain basic gain sequence. Consequently, the necessary information amount as the correction characteristic table can be significantly reduced. That is, the burden of the correction characteristic table used for parameter calculation is also significantly reduced.

BRIEF DESCRIPTION OF THE DRAWINGS

Fig. 1 is a block diagram of an audio reproduction device according to an embodiment of the present invention;
Figs. 2A to 2C are explanatory diagrams of parameter calculation operation in the embodiment;
Figs. 3A to 3C are explanatory diagrams of processing when a Q value is Q0 in the embodiment;
Figs. 4A to 4C are explanatory diagrams of processing when a Q value is Q1 in the embodiment;
Figs. 5A to 5C are explanatory diagrams of processing when a Q value is Q2 in the embodiment;
Figs. 6A to 6C are explanatory diagrams of sample points arising from frequency analysis in the embodiment;
Figs. 7A and 7B are explanatory diagrams of sample points used for parameter calculation in the embodiment;
Fig. 8 is an explanatory diagram of sample points arising from frequency analysis and sample points used for parameter calculation in the embodiment;
Fig. 9 is an explanatory diagram of parameter calculation operation for a second band in the embodiment;
Fig. 10 is an explanatory diagram of a correction characteristic table in the embodiment;
Fig. 11 is an explanatory diagram of a gain sequence stored in the correction characteristic table in the embodiment;
Fig. 12 is a flowchart of parameter calculation processing in the embodiment;
Figs. 13A to 13C are explanatory diagrams of frequency parallel movement in the embodiment;
Figs. 14A to 14C are explanatory diagrams of frequency parallel movement in the embodiment;
Figs. 15A and 15B are explanatory diagrams of compression of a gain sequence in the embodiment;
Fig. 16 is an explanatory diagram of compression of a gain sequence in the embodiment;
Fig. 17 is a flowchart of parameter calculation processing in the embodiment; and
Figs. 18A to 18D are explanatory diagrams of processing for obtaining a correction characteristic in the embodiment.

DETAILED DESCRIPTION OF THE PREFERRED EMBODIMENT

An embodiment of the present invention will be described below in the following order:

[1. Configuration of Audio Reproduction Device]
[2. Setting of Parameters of Parametric Equalizer]
[3. Reduction in Information Amount of Correction Characteristic Table]

[1. Configuration of Audio Reproduction Device]

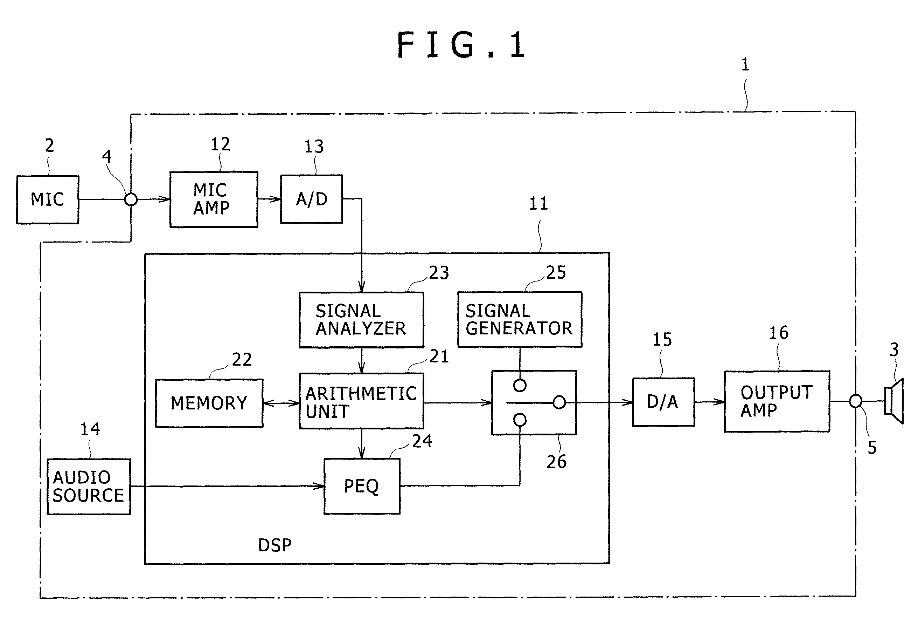

Fig. 1 shows the configuration of an audio reproduction device that is one form of an audio output device according to an embodiment of the present invention. The audio reproduction device is realized as e.g. a vehicle or home audio reproduction device.

An audio reproduction device 1 outputs from a speaker 3 connected thereto an audio signal produced by an audio source 14. As the audio source 14, e.g. a reproduction device that reproduces an audio signal from an optical disc such as a compact disc (CD) or digital versatile disc (DVD) or a tuner device that receives/demodulates radio broadcasting to output an audio signal would be available. Alternatively, the audio source 14 may be a reproduction device that reproduces an audio signal from a memory card or a tape player device that reproduces an audio signal from a hard disc drive (HDD), magnetic tape or the like.

An audio signal (digital audio signal) output from the audio source 14 is input to a DSP 11 as a signal processor.

The audio signal is subjected to requisite audio signal processing in the DSP 11, and then is converted into an analog audio signal by a D/A converter 15. The analog audio signal is subjected to amplification processing by an output amplifier 16 for speaker output, followed by being output as audio from the speaker 3 connected to a terminal 5.

Although the drawing shows only one speaker 3 for simplification, it should be obvious that the device 1 is connected to plural speakers in the same number as that of channels, such as L and R speakers for L and R stereo audio signals or four speakers for four-channel stereo signals (e.g. front L and R, and rear L and R speakers). Furthermore, although the drawing shows only one serial-system formed of the audio processing system in the DSP 11, the D/A converter 15, and the output amplifier 16, plural serial-systems each including these units are provided for plural channels.

In the DSP 11, various kinds of processing, such as frequency characteristic correction (equalizing), channel division, acoustic correction, and volume adjustment, are executed for an audio signal.

Of units for these processing, only a parametric equalizer 24 for the frequency characteristic correction is shown in Fig. 1. In an actual device 1, plural parametric equalizers 24 are provided for plural channels.

The DSP 11 includes also an arithmetic unit 21, a memory 22, a signal analyzer 23, a selector 26, and a signal generator 25.

The signal analyzer 23 executes e.g. the Fast Fourier Transform (FFT) analysis on an input audio signal to thereby obtain the frequency characteristic of the signal.

The arithmetic unit 21 calculates parameters of the parametric equalizer 24 by using the frequency characteristic obtained by the signal analyzer 23. Specifically, the arithmetic unit 21 calculates parameters for correcting the analyzed frequency characteristic to a predetermined target frequency characteristic. The calculated parameters are supplied to the parametric equalizer 24. The parameters of the parametric equalizer 24 are the center frequency, gain value, and Q value (sharpness of a correction characteristic). If the parametric equalizer 24 is to adjust the frequency characteristics of n bands, the center frequency, gain, and Q value of each band are calculated.

The memory 22 holds therein a correction characteristic table used for the parameter calculation. In the correction characteristic table, values as gain sequences corresponding to various center frequencies, gains, and Q values are stored.

The signal generator 25 outputs a measurement signal (signal to be measured) for sound field adjustment. The measurement signal is e.g. a time stretched pulse (TSP), or alternatively may be a signal as white noise, pink noise or the like.

The selector 26 selects a measurement signal from the signal generator 25 or audio signal processed by the parametric equalizer 24 as a signal to be output from the speaker. At the time of general audio reproduction, the selector 26 selects a signal from the parametric equalizer 24, so that an audio signal reproduced by the audio source 14 is output from the speaker. In contrast, in calculation/setting of parameters of the parametric equalizer 24 for sound field adjustment, to be described later, the signal generator 25 is selected, so that audio based on a measurement signal is output from the speaker.

A microphone 2 is connected to a terminal 4. The microphone 2 collects audio at e.g. a position as a listening point for sound field correction. The audio signal obtained through the microphone 2 is input via the terminal 4 to a microphone amplifier 12 and amplified therein. The resultant signal is converted into digital audio data by an A/D converter 13, followed by being supplied to the signal analyzer 23.

In this audio reproduction device, parameters of the parametric equalizer 24 are automatically calculated and set through the sound field adjustment, so that a sound field space that is favorable at the listening point of a user is formed.

For the sound field adjustment, the microphone 2 is connected in the above-described manner and disposed at the listening point of a user.

In a general home or vehicle space, there is diversity in the transfer characteristic of sound from the speaker position to the listening point. Therefore, the audio reproduction device 1 internally has an equalizer and thereby corrects the characteristic for creation of an ideal sound field space.

For this sound field adjustment in the present example, the signal generator 25 generates a measurement signal, and the signal is output from the speaker 3. The audio by the measurement signal is collected by the microphone 2 placed at the listening point, and the signal analyzer 23 analyzes the frequency characteristic of the collected audio signal.

Based on the analysis result, the arithmetic unit 21 calculates parameters of the parametric equalizer 24 for sound field correction.

In the processing for calculating parameters of the parametric equalizer 24, to be described later, parameters for correcting the frequency characteristic obtained from the measurement signal to a target frequency characteristic are calculated.

If the audio reproduction device 1 is a multichannel stereo audio system connected to plural speakers 3, the above-described calculation/setting of parameters for sound field adjustment is executed for each channel. For example, if the device 1 is provided with a speaker system formed of front R and L and rear R and L speakers, initially for adjustment of the front R channel, a measurement signal is output only from the front R speaker, and the microphone 2 collects the output audio, followed by frequency characteristic analysis and parameter calculation. The calculated parameters are set as parameters of the parametric equalizer 24 for the front R channel.

Subsequently, for adjustment of the front L channel, a measurement signal is output only from the front L speaker, and the microphone 2 collects the output audio, followed by frequency characteristic analysis and parameter calculation. The calculated parameters are set as parameters of the parametric equalizer 24 for the front L channel.

Also for the rear L and R channels, parameters of the parametric equalizers 24 corresponding to the respective channels are calculated and set in a similar manner.

The setting of parameters of the parametric equalizer 24 will be described below. This description relates to calculation of parameters of the parametric equalizer 24 on one channel.

[2. Setting of Parameters of Parametric Equalizer]

A description will be made below about setting of parameters of the parametric equalizer 24, which is a feature of the present embodiment. The parametric equalizer 24 is to adjust the frequency characteristics of multiband (n bands). Furthermore, the parameters (center frequency, gain, Q value) of each band are calculated so that a measured frequency characteristic may be brought close to a target frequency characteristic in a certain frequency range.

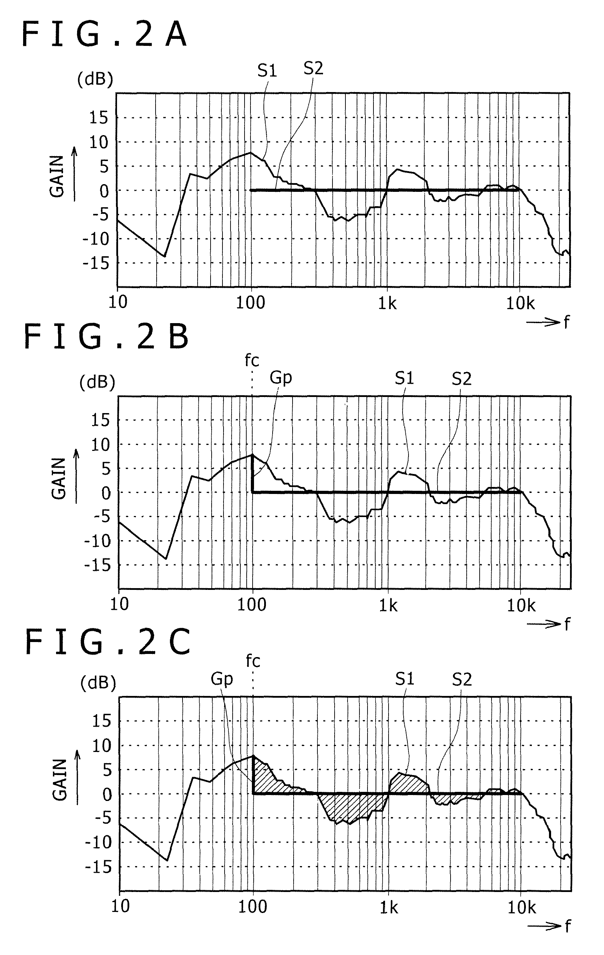

Fig. 2A shows, as a measured frequency characteristic S1, an example of a frequency characteristic resulting from collection of a measurement signal through the microphone 2 and analysis of the signal by the signal analyzer 23.

In addition, a target frequency characteristic S2 is indicated by the flat straight line (heavy line) in the range of 100 Hz to 10 kHz in Fig. 2A.

In the following, parameter calculation for converting the measured frequency characteristic S1 to the target frequency characteristic S2 will be described as an example.

Initially a description will be made about sample points of a frequency characteristic. By the FFT analysis in the signal analyzer 23, the gains of frequency points at e.g. 20-Hz intervals (the intervals are not limited thereto of course) are obtained.

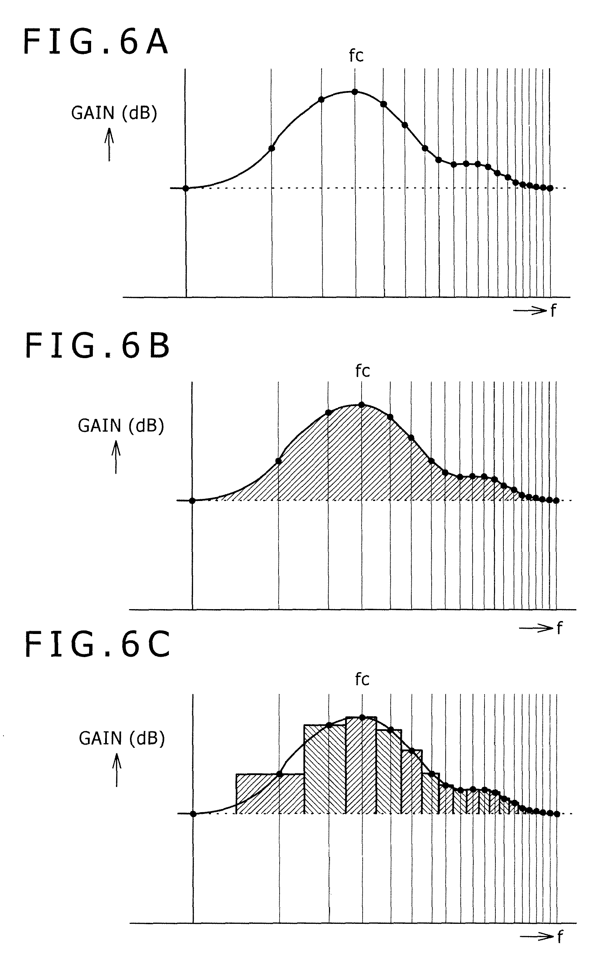

Fig. 6A is a diagram of which abscissa indicates a frequency axis on a Log scale and of which ordinate indicates a gain. The signal analyzer 23 obtains, as a certain frequency characteristic, the gains of frequency points that are represented at equal intervals when being plotted on a linear scale, such as frequency points at frequencies 100 Hz, 120 Hz, 140 Hz, 160 Hz ⋯. These gains of the respective frequency points are indicated by ● (black circle) in Fig. 6A. That is, the frequency points as the respective sample points do not have equal intervals on a Log scale. On a Log scale, the distance between the sample points becomes smaller as the frequencies of the sample points become higher.

In the present example, the arithmetic unit 21 calculates parameters by using the analysis result by the signal analyzer 23. In this calculation, frequency points that are represented at equal intervals on a Log scale are used as sample points for the calculation.

In Fig. 7A, sample points having equal intervals on a Log scale are indicated by o (white circle). For example, the points ● in Fig. 6A indicate the frequency points of 100 Hz, 120 Hz, 140 Hz, 160 Hz ⋯ , while the points o in Fig. 7A indicate the frequency points of 100 Hz, 200 Hz, 400 Hz, 800 Hz ⋯. As shown in Fig. 7A, these frequency points are represented at positions having equal intervals when being plotted on a Log scale.

The arithmetic unit 21 extracts from the sample points ● as the result of the frequency characteristic analysis, only the sample points o, which have equal intervals on a Log scale. Subsequently, the arithmetic unit 21 executes the following parameter calculation.

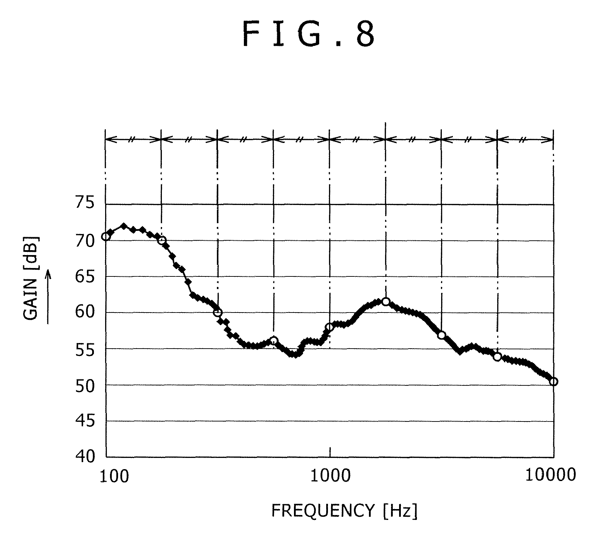

Fig. 8 shows a certain measured frequency characteristic. In Fig. 8, points ♦ (black diamond) indicate sample points as frequency points having equal intervals on a linear scale, while points o indicate sample points having equal intervals on a Log scale. Of these sample points, only the sample points o are actually used as the measurement result. The center frequency, gain to be corrected, and Q value are determined based on the thus limited sample points.

There would be a possibility that sample points on a measured frequency characteristic do not exactly correspond with frequency points having equal intervals on a logarithmic axis. In this case, sample points that are as close to the frequency points having equal intervals as possible are employed so that the employed points may have substantially equal intervals on the logarithmic axis.

This means that the sample points o do not need to have exactly equal intervals as long as no problem arises in operation for obtaining a difference area to be described later, in which the sum of the differences in the gain between the sample points o and the corresponding points on a target frequency characteristic is regarded as the difference area of a Q-value candidate.

In the parameter calculation for converting the measured frequency characteristic S1 to the target frequency characteristic S2 in Fig. 2A, initially a center frequency fc and a gain are obtained as parameters of a first band.

In the present example, from the measured frequency characteristic S1, the frequency offering the largest gain difference with respect to the target frequency characteristic S2 is detected from the correction-target frequency range (e.g. from 100 Hz to 10 kHz). The detected frequency is defined as the center frequency fc, and the largest gain difference Gp is defined as the gain to be corrected.

In the case of the measured frequency characteristic S1 and the target frequency characteristic S2 in Fig. 2A, the center frequency fc is 100 Hz and the gain is about 7 dB as shown in Fig. 2B.

Subsequently, a Q value (sharpness of a correction characteristic) is determined, so that all parameters of one band for correction are determined.

As a method for determining the optimum Q value, a method is available in which the Q value offering the smallest difference area between the frequency characteristic as the correction result and the target frequency characteristic S2 is selected (it is necessary that the frequency axis for the difference area calculation be on a Log scale).

For example, the area of the hatched part in Fig. 2C indicates the difference area between the measured frequency characteristic S1 and the target frequency characteristic S2.

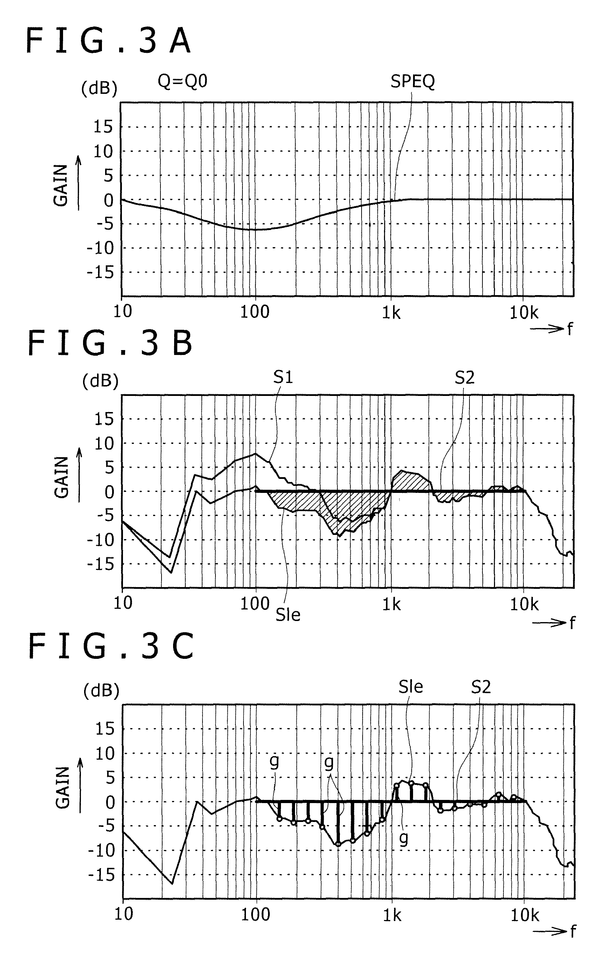

The processing for selecting the Q value through difference area comparison will be described below with reference to Figs. 3, 4 and 5.

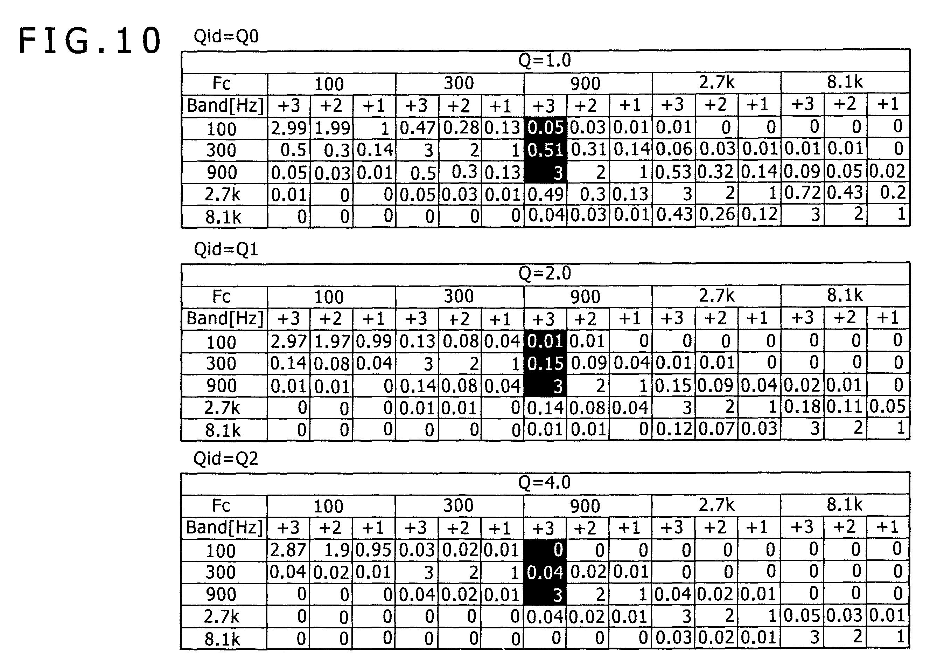

In the present example, three Q values are prepared as candidates for the Q value that can be selected, and these Q values are defined as Q0, Q1, and Q2. For example, Q0 is 0.5, Q1 is 1.5, and Q2 is 3.5. In the correction characteristic table of Fig. 10 to be described later, an example in which Q0 is 1.0, Q1 is 2.0, and Q2 is 4.0 is shown.

Fig. 3A shows a correction characteristic SPEQ when the Q value is Q0. Fig. 3B shows a corrected frequency characteristic S1e resulting from correction of the measured frequency characteristic S1 by the correction characteristic SPEQ corresponding to Q0.

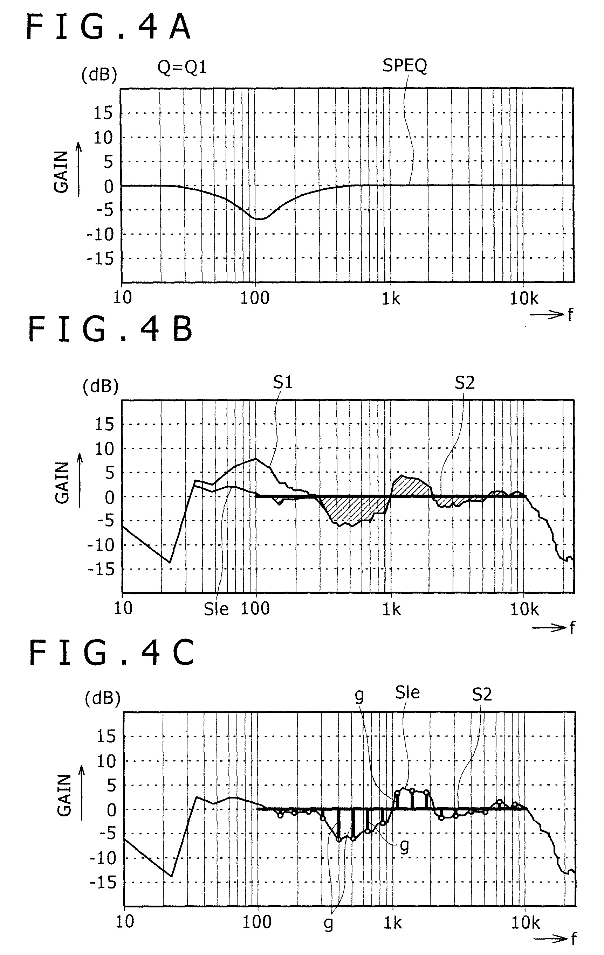

Fig. 4A shows the correction characteristic SPEQ when the Q value is Q1. Fig. 4B shows the corrected frequency characteristic S1e resulting from correction of the measured frequency characteristic S1 by the correction characteristic SPEQ corresponding to Q1.

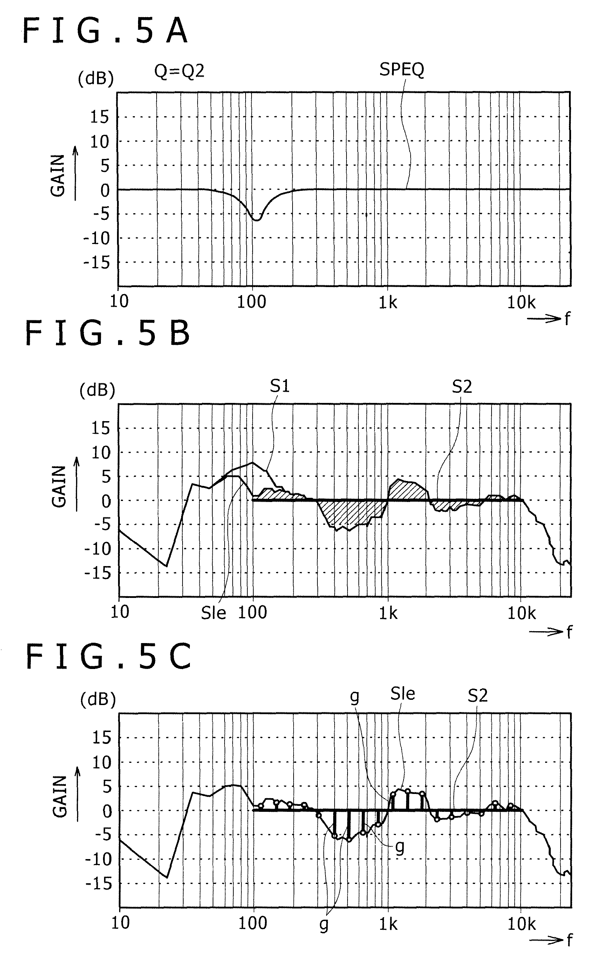

Fig. 5A shows the correction characteristic SPEQ when the Q value is Q2. Fig. 5B shows the corrected frequency characteristic S1e resulting from correction of the measured frequency characteristic S1 by the correction characteristic SPEQ corresponding to Q2.

For each of three Q-value candidates, the difference area between the frequency characteristic as the correction result and the target frequency characteristic S2 is obtained. Specifically, the areas of the hatched parts shown in Figs. 3B, 4B, and 5B are obtained.

In this example, the difference area when the Q value is Q1 (Fig. 4B) is the smallest, and therefore Q1 is determined as the optimum Q value.

For this determination, the difference area indicated by the hatched part is calculated for each Q value. In the present example, the difference area is obtained as the sum of differences in the gain between the respective sample points having equal intervals on a Log-scale frequency axis and corresponding points on a target frequency characteristic. This allows significantly simplified arithmetic operation.

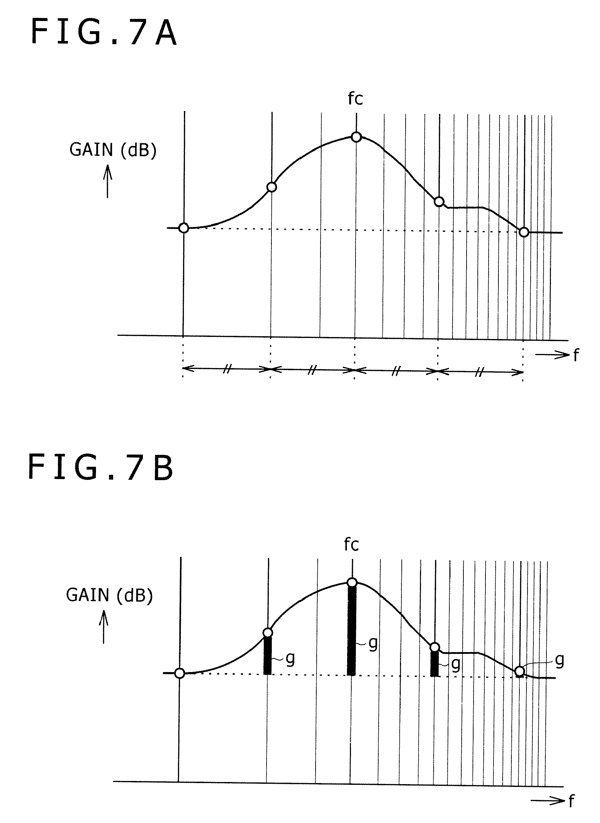

This feature will be described below with reference to Figs. 6 and 7. In the example of Fig. 6A, in which the above-described frequency characteristic is shown, the target frequency characteristic is a flat characteristic indicated by the dashed line. In this case, the difference area is equivalent to the area of the hatched part in Fig. 6B. If the gains of frequency points as the sample points ● having equal intervals on a linear scale have been obtained for example, the scheme shown in Fig. 6C is employed for the difference area calculation. Specifically, in this scheme, rectangular regions each having a height corresponding to the gain difference of a sample point ● (absolute value of the gain difference) are defined, and the area of the rectangular region of each sample point ● is calculated. The total sum of the areas of the rectangular regions is defined as the difference area shown in Fig. 6B.

In this scheme, however, because the sample points ● do not have equal intervals on a Log scale, the width of the rectangular region is different on each sample point basis (the width of the rectangle becomes smaller as the frequency of the sample point becomes higher). This greatly complicates the arithmetic for obtaining the areas of the rectangular regions.

In contrast, the present example employs only the sample points o having equal intervals on a Log scale as shown in Fig. 7A. In this case, the value equivalent to a difference area like that shown in Fig. 6B can be obtained as the sum of the differences in the gain between the respective sample points o and corresponding points on a target frequency characteristic. Specifically, Fig. 7B shows the difference g in the gain between each sample point O and the corresponding point on a target frequency characteristic. The total sum of the differences g can be regarded as the value equivalent to the difference area. This is because the respective sample points o are frequency points having equal intervals on a Log scale. That is, a difference area (value equivalent to a difference area) can be calculated only through simple arithmetic operation of merely adding the gain differences g to each other.

A description will be made below regarding the cases where this simple scheme is applied to the examples of Figs. 3, 4 and 5.

When the difference area of the hatched part in Fig. 3B is to be obtained, as shown in Fig. 3C, the sum of the absolute values g of the gain differences between the sample points o having equal intervals on a Log scale and the corresponding points on the target frequency characteristic S2 is obtained. This sum can be regarded as the difference area for evaluation of the case where the Q value is Q0.

Similarly, when the difference area of the hatched part in Fig. 4B is to be obtained, as shown in Fig. 4C, the sum of the absolute values g of the gain differences between the sample points o and the corresponding points on the target frequency characteristic S2 is obtained, so that the sum is regarded as the difference area for evaluation of the case where the Q value is Q1.

Similarly, when the difference area of the hatched part in Fig. 5B is to be obtained, as shown in Fig. 5C, the sum of the absolute values g of the gain differences between the sample points o and the corresponding points on the target frequency characteristic S2 is obtained, so that the sum is regarded as the difference area for evaluation of the case where the Q value is Q2.

That is, the arithmetic for obtaining the difference area of each Q-value candidate can be executed only through simple addition operation. The Q-value candidate offering the smallest difference area is determined as the optimum Q value.

In the above-described manner, the center frequency fc, gain, and Q value are determined as the parameters of one band.

In the present example, to thus determine the center frequency fc, gain, and Q value, the candidates for the center frequency point to be corrected are limited by equally dividing the frequency range as the correction range on a logarithmic axis. That is, the candidate points are limited to the above-described sample points o.

As a method for selecting the Q value, a method is employed in which the Q value offering the smallest difference area between the corrected frequency characteristic S1e and the target frequency characteristic S2 is selected. For the difference area calculation, an approximation method is employed. Specifically, the area is obtained as the sum of the absolute values of the differences between the measured values of the respective frequency points arising from equal division of a frequency range and the corresponding target values.

This approximation method allows difference areas to be approximately calculated in accordance with Equation 1 so as to be compared with each other, as long as gain sequences corresponding to the relevant center frequencies fc, gains, and Q values (correction characteristic table to be described later) are prepared in advance. Furthermore, if the center frequency and gain can be found, all the optimum parameters of the parametric equalizer 24 can be determined through calculation of the difference area of each Q-value candidate and selection of the Q-value candidate offering the smallest difference area.

$$\sum_{i=0}^{N-1} \left| Target[i] - GainArray[i] \right| \quad \dots Equation\ 1$$

In Equation 1, i denotes the frequency index (index of frequency points employed as sample points o). N denotes the number of frequency points as the candidates for the center frequency point (the number of the sample points o). Target[i] denotes the measured frequency characteristic S1 or the frequency characteristic S1e resulting from one or more times of correction by an equalizer. GainArray[i] denotes an equalizer characteristic sequence corresponding to a certain Q value, center frequency, and gain.

If the parameters of the parametric equalizer for one band have been determined in the above-described manner (in the case of the above-described example, the center frequency fc is 100 Hz, the gain is 7 dB, and the Q value is Q1 (e.g. Q1 = 1.5)), the corrected frequency characteristic to which the correction effect by the equalizer has been added can be calculated. From the corrected frequency characteristic, the frequency offering the largest gain difference with respect to the target characteristic is calculated, so that the above-described correction routine is repeatedly executed for the corrected frequency characteristic. This correction repetition allows effective correction of multiband by the parametric equalizer.

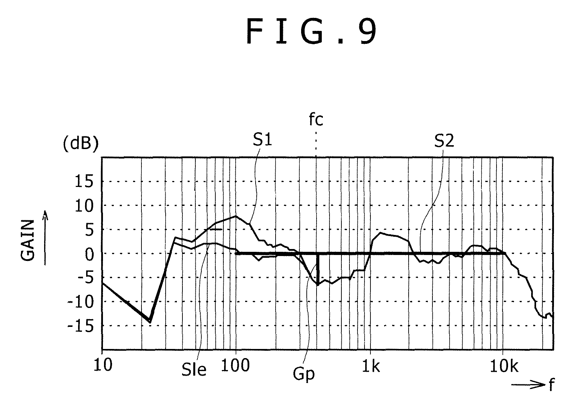

For example, the measured frequency characteristic S1 shown in Fig. 9 is converted to the corrected frequency characteristic S1e through equalizing of one band with the following parameters: a center frequency fc of 100 Hz, gain of 7 dB, and Q value of 1.5. Subsequently, by using the corrected frequency characteristic S1e, parameters for equalizing of a second band are calculated.

Specifically, as shown in Fig. 9, of the sample points (sample points o having equal intervals on a Log scale) on the corrected frequency characteristic S1e, the point offering the largest absolute value of the gain difference Gp is defined as the point of the center frequency fc, and the gain Gp is determined as the gain to be corrected.

Subsequently, for each of plural Q-value candidates, the corrected frequency characteristic corresponding to the obtained center frequency fc and gain is obtained, and the difference area between the corrected frequency characteristic and the target frequency characteristic is calculated as the sum of the absolute values of the gain differences of the respective sample points o as described above. The Q value offering the smallest difference area is selected.

Furthermore, the correction effect by the equalizing of the second band (encompassing also the effect for the first band) is added to the frequency characteristic, and then the parameters of a third band are determined similarly.

In this manner, the parameter calculation is sequentially carried out for all the bands from the first to the n-th band. The correction effect of the previous bands is added to the frequency characteristic before every calculation.

Only simple four arithmetic operations expressed in Equation 1 are executed as the operations executed until completion of the parameter calculation for the n-th band.

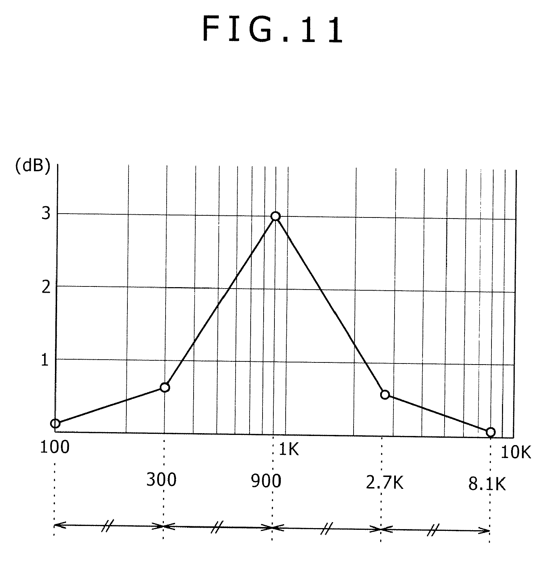

With reference to Figs. 10 and 11, a description will be made below about an example of a correction characteristic table for the above-described parameter calculation and, in particular, achievement of correction characteristics for Q-value selection.

The correction characteristic table includes gain sequences corresponding to certain center frequencies fc, gains, and Q values.

The example of Fig. 10 shows a correction table for three Q-value candidates Qid = Q0, Q1, and Q2. Qid denotes the Q-value candidate number. In this example, Q0 is 1.0, Q1 is 2.0, and Q2 is 4.0.

A description will be made below about the table for Qid = Q0. In this table, frequencies 100 Hz, 300 Hz, 900 Hz, 2.7 kHz, and 8.1 kHz are defined as the candidates for the center frequency fc. The frequency points of these frequencies are equivalent to sample points o having equal intervals on a Log scale. Note that the number of frequency points is set to a small number (five) in this example for simplification of the description and illustration. An actual table includes a much larger number of frequency points equivalents to the sample points o as candidates for the point of the center frequency fc.

Furthermore, for each of the frequency points that can be the point of the center frequency fc, the following gains are assumed: - 3, - 2, - 1, + 1, + 2, and + 3. Thus, for each frequency point, the gain sequences corresponding to the gains + 1, + 2, and + 3, respectively, are stored (the negative values of these gain sequences can be used as the gain sequences corresponding to the gains - 1, - 2, and - 3, respectively).

As the gain sequence, the gains corresponding to the frequencies 100 Hz, 300 Hz, 900 Hz, 2.7 kHz, and 8.1 kHz, respectively, are stored.

For example, as the gain sequence for the center frequency fc of 900 Hz and a gain of + 3, values "0.05," "0.51," "3," "0.49," and "0.04" are stored as the gains corresponding to the frequencies 100 Hz, 300 Hz, 900 Hz, 2.7 kHz, and 8.1 kHz, respectively (meaning of the white characters (reverse printing) for a part of the values in the table will be described later).

These values for the center frequency fc of 900 Hz, gain of + 3, and Q value of 1.0 correspond to the gain sequence as the correction characteristic shown in Fig. 11.

The number of frequency points for which gains are stored as a gain sequence is also five similarly to the number of frequency points as the candidates for the point of the center frequency fc. This is also for simplification. As an actual gain sequence, gains corresponding to a much larger number of frequency points equivalents to sample points o having equal intervals on a Log scale are stored.

Such a correction characteristic table is stored in the memory 22 so that the arithmetic unit 21 can refer to the table. This allows the above-described parameter determination processing, in particular, the Q-value determination.

For example, when the center frequency fc and gain are determined as shown in Fig. 2B, the correction characteristics of the respective Q values shown in Figs. 3A, 4A, and 5A are obtained. The gain sequences as these correction characteristics can be found from the correction characteristic table. That is, the gain sequence can be retrieved by searching the correction characteristic table depending on the determined center frequency fc and gain.

After the gain sequence (correction gains for the sample points o) is thus retrieved, each gain in the gain sequence is added to or subtracted from the gain of the corresponding sample point o on the measured frequency characteristic S1. This operation allows achievement of the corrected frequency characteristic S1e shown in Figs. 3B, 4B, and 5B.

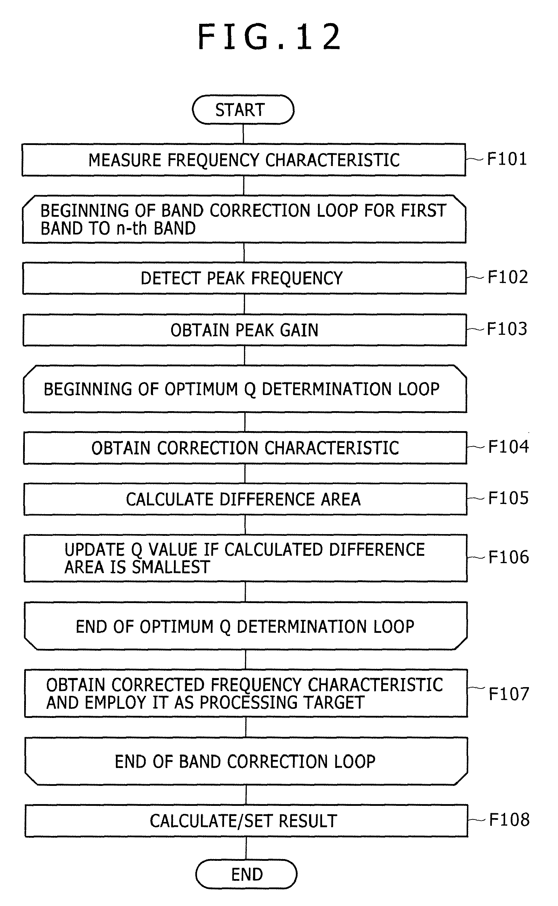

Fig. 12 shows processing executed by the audio reproduction device 1 as the processing for calculating parameters of the parametric equalizer 24 described with Figs. 2 to 11.

In the above-described parameter calculation/setting for sound field adjustment, an adjustment signal generated from the signal generator 25 is output from the speaker 3, and the output audio is collected through the microphone 2. Fig. 12 shows the processing in the DSP 11 from input of the audio signal collected through the microphone 2 to determination of parameters.

In a step F101, the frequency characteristic of an input audio signal from the microphone 2 is measured by the signal analyzer 23. That is, the measured frequency characteristic S1 shown in Figs. 2 to 5 is obtained. As the frequency characteristic, the gains of sample points ● having equal intervals on a linear scale like those shown in Fig. 6A are analyzed.

Subsequently, as a band correction loop, steps F102 to F107 are repeated n times by the arithmetic unit 21 (processing from the beginning to the end of the band correction loop).

Specifically, if the parametric equalizer 24 is to execute frequency characteristic correction processing for n bands, the steps F102 to F107 are carried out for each of the bands from the first band to the n-th band.

Initially for the first band, in the step F102, the peak frequency in the measured frequency characteristic S1 obtained in the step F101 is detected. In the step F102, initially sample points o having equal intervals on a Log scale are extracted from the sample points ● on the linear scale. The absolute values of the differences in the gain between the frequency points as the sample points o and the corresponding frequency points on the target frequency characteristic S2 are compared with each other, so that the sample point o offering the largest absolute value is determined as the point of the peak frequency. This peak frequency is defined as the center frequency fc as a parameter of the first band.

Subsequently, in the step F103, the peak gain is obtained. This peak gain is equivalent to e.g. the difference Gp in Fig. 2B, i.e., the difference in the gain between the point of the center frequency fc and the corresponding frequency point on the target frequency characteristic S2. This peak gain is defined as the gain as a parameter of the first band.

The obtaining of the center frequency fc and gain is followed by the processing of the steps F104 to F106 as an optimum Q determination loop (processing from the beginning to the end of the optimum Q determination loop).

This processing of the steps F104 to F106 is repeated the same number of times as the number of Q-value candidates as parameter candidates. If three kinds of Q value Q0, Q1, and Q2 are prepared as the Q-value candidates as described above, the processing of the steps F104 to F106 is repeated three times. That is, the processing is executed for each Q value.

Initially in the step F104, the correction characteristic corresponding to the Q value Q0 is obtained. Specifically, a gain sequence is retrieved with reference to the above-described correction characteristic table based on the determined center frequency fc and gain. This operation offers the correction characteristic SPEQ shown in Fig. 3A for example.

Subsequently, in the step F105, the difference area is obtained as the area of the hatched part in Fig. 3B for example. For the difference area calculation, initially the corrected frequency characteristic S1e resulting from correction of the measured frequency characteristic S1 by the correction characteristic SPEQ is obtained. The obtaining of the corrected frequency characteristic S1e is followed by calculation of the sum of the absolute values g of the gain differences between sample points o on the corrected frequency characteristic S1e, having equal intervals on a Log scale, and the corresponding frequency points on the target frequency characteristic S2. The calculated sum is defined as the difference area for evaluation of the case where the Q value is Q0.

In the step F106, if the calculated difference area is the smallest, the Q value and the difference area obtained in the present processing are held. The difference area obtained by this first loop is the smallest of course, and hence the Q value Q0 and the difference area are held.

Subsequently, the processing sequence returns to the step F104, where the correction characteristic corresponding to the Q value Q1 is obtained from the correction characteristic table in a similar manner. Specifically, the correction characteristic SPEQ shown in Fig. 4A is obtained for example. Subsequently, in the step F105, the difference area is obtained as the area of the hatched part in Fig. 4B through similar arithmetic.

In the step F106, the present difference area is compared with the held difference area, and the smaller difference area and the corresponding Q value are held.

Furthermore, the processing sequence returns to the step F104 again, where the correction characteristic corresponding to the Q value Q2 is obtained from the correction characteristic table similarly. Specifically, the correction characteristic SPEQ shown in Fig. 5A is obtained for example. Subsequently, in the step F105, the difference area is obtained as the area of the hatched part in Fig. 5B through similar arithmetic.

In the step F106, the present difference area is compared with the held difference area, and the smaller difference area and the corresponding Q value are held.

If the number of kinds of Q value candidate is three, the optimum Q value is determined through the above-described three times of loop processing. That is, the Q value finally held in the step F106 is determined as the Q value as a parameter of the first band.

In the next step F107, the corrected frequency characteristic S1e resulting from the correction of the first band based on the determined parameters (center frequency fc, gain, and Q value) is obtained. The corrected frequency characteristic S1e is defined as the processing target for calculation of parameters of the next band.

Subsequently, the processing sequence returns to the step F102, and thereafter parameters for the second band are calculated similarly. In the step F102 and subsequent steps, the processing is executed not for the measured frequency characteristic S1 obtained at the beginning but for the corrected frequency characteristic S1e resulting from the correction with the parameters determined for the first band.

Thereafter, the steps F102 to F107 are repeated until the n-th band, so that the parameters of each band are calculated.

Subsequently, in a step F108, the center frequencies fc, gains, and Q values obtained through the processing of the steps F102 to F107 are determined as the parameters of the respective bands so as to be set in the parametric equalizer 24.

The completion of the step F108 is equivalent to the completion of the setting of the parameters of the parametric equalizer 24 for correcting the frequency characteristic of an audio signal collected through the microphone 2 so that this frequency characteristic may be brought close to the target frequency characteristic S2.

As described above, in the present embodiment, sample points having equal intervals (substantially equal intervals) on a Log-scale frequency axis are extracted from the respective sample points of which gains have been found through frequency analysis. Subsequently, parameters of an equalizer are calculated by using the differences in the gain between the extracted sample points and the frequency points on a target frequency characteristic corresponding to the extracted sample points. In particular, of the sample points having equal intervals on the Log-scale frequency axis, the frequency of the sample point offering the largest gain difference with respect to the target frequency characteristic is defined as the center frequency. Furthermore, the gain difference between the sample point defined as the point of the center frequency and the corresponding frequency point on the target frequency characteristic is defined as the gain as a parameter. Subsequently, based on the determined center frequency and gain, the corrected frequency characteristics each corresponding to a respective one of plural Q-value candidates are obtained, and the difference areas between the corrected frequency characteristics and the target frequency characteristic are calculated. The Q value offering the smallest difference area is defined as the Q value as a parameter. The difference area for the Q-value determination is obtained as the sum of the differences in the gain between the respective sample points having equal intervals (subsequently equal intervals) on the Log-scale frequency axis and the corresponding frequency points on the target frequency characteristic.

Therefore, the parameters of the parametric equalizer 24 for multiband can be calculated only through addition and subtraction of integer-type variables. This calculation can be executed even by a low-speed and low-function arithmetic unit (e.g. a cheap microcomputer or DSP), and hence can be easily employed in various audio output devices at low costs.

[3. Reduction in Information Amount of Correction Characteristic Table]

For the above-described parameter calculation, there is a need to hold in a correction characteristic table all the gain sequences corresponding to the relevant center frequencies fc, gains, and Q values. The example in Fig. 10 is a simplified table for convenience of explanation. However, for example, an actual table would cover 24 sample points o that can be the point of the center frequency fc and have equal intervals on a Log scale, 17 gains from - 8 dB to + 8dB with 1dB intervals, and three or more kinds of Q-value candidate. It would be also possible, of course, that the number of sample points o is 25 or more, and the number of gains is larger.

A larger number of these parameters leads to a larger data size of a correction characteristic table, and would possibly result in an unfavorable situation due to heavy burden of a memory.

To address this, the present embodiment can employ a method that allows reduction in the information amount of a correction characteristic table.

In particular, when a parametric equalizer is used, the correction characteristic thereof is symmetric on a Log scale. Furthermore, in the present example, sample points having equal intervals on a Log scale are employed as the respective points of a gain sequence as a correction characteristic. Therefore, the following method can be realized.

In general, gain sequences as correction characteristics of a parametric equalizer have the following characteristic: gain sequences corresponding to the same Q value and gain show the same shape, when being plotted on a logarithmic axis, irrespective of the center frequency.

Therefore, if frequency points of a gain sequence have equal intervals on a logarithmic axis like in the present example, even when data as a gain sequence is shifted along the logarithmic axis, the resultant data shows substantially the same curve as that of the before-shift data.

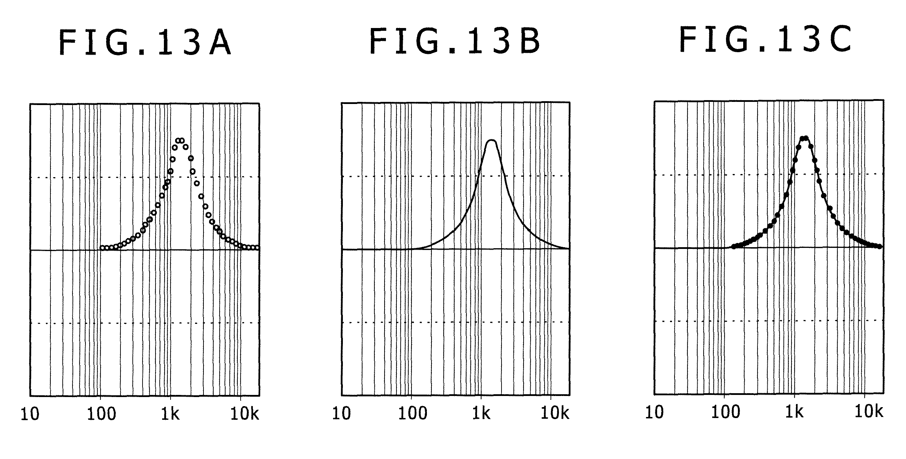

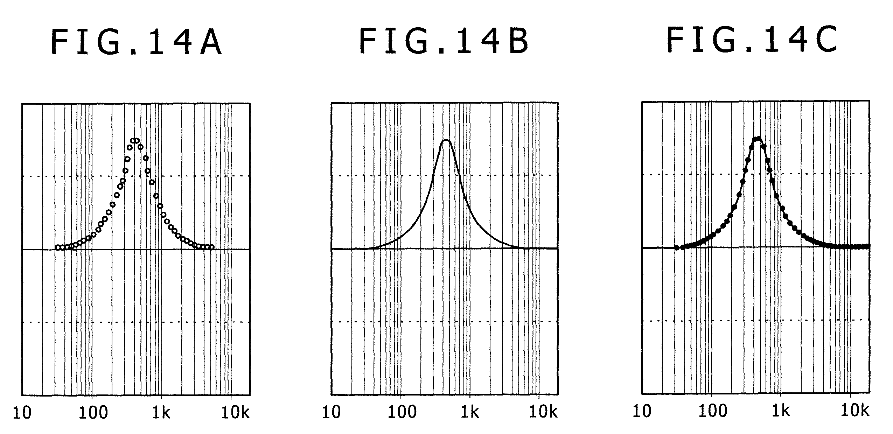

Figs. 13 and 14 show one example of this characteristic equivalence.

Fig. 13B shows an ideal frequency characteristic when the Q value is 1.0, the center frequency fc is 1.5 kHz, and the gain is 6 dB.

Fig. 13A shows a characteristic represented by sample points having equal intervals on a logarithmic axis in the range of 100 Hz to 20 kHz. Fig. 13C is a diagram resulting from superposition of Fig. 13A on Fig. 13B. These characteristics substantially match each other of course.

Fig. 14B shows an ideal frequency characteristic when the Q value is 1.0 and the gain is 6 dB, as with the characteristic of Fig. 13B, but the center frequency fc is 500 Hz.

Fig. 14A is a characteristic created by shifting the gain sequence of Fig. 13A to the left in the frequency axis direction so that the peak frequency of the shifted characteristic be about 500 Hz, and interpolating zero for data absence on the higher frequency side in the original characteristic.

Fig. 14C is a diagram resulting from superposition of Fig. 14A on Fig. 14B. As shown in Fig. 14C, the characteristic created by shifting the gain sequence in the frequency axis direction substantially matches the ideal characteristic.

In this manner, correction characteristics corresponding to various center frequencies can be derived from a correction characteristic corresponding to one certain center frequency by horizontally shifting the correction characteristic in the frequency axis direction and interpolating zero for data absence. That is, as long as one gain sequence is held for the same Q value and gain, gain sequences do not need to be held on each center frequency basis.

This means that a correction characteristic table does not need to hold data of a gain sequence for each of sample points o that can be the point of the center frequency fc.

Furthermore, in the present example, sample points having equal intervals on a Log scale are used, and the gains of frequency points as the sample points o are held as a gain sequence. Therefore, the characteristic curve by the gain sequence is substantially symmetric across the peak frequency. For example, Fig. 11 shows a gain sequence of which peak gain appears at a frequency of 900 Hz. In this gain sequence, the gains at frequencies 300 Hz and 2.7 kHz are substantially identical to each other, and hence employing the same value for these gains leads to no problem. In addition, the gains at frequencies 100 Hz and 8.1 kHz are also substantially identical to each other, and hence employing the same value for these gains causes no problem.

That is, it is sufficient that only gains on one side from a peak gain are held as a gain sequence for a certain Q value and gain. For example, for the characteristic of Fig. 11, the gains at frequencies 100 Hz, 300 Hz, and 900 Hz may be held, and the gains at frequencies 100 Hz and 300 Hz may be used as the gains at frequencies 2.7 kHz and 8.1 kHz.

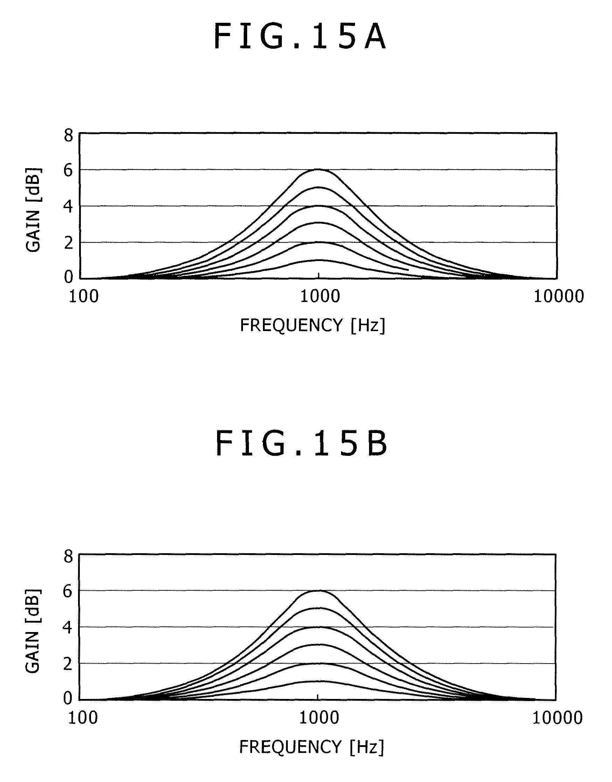

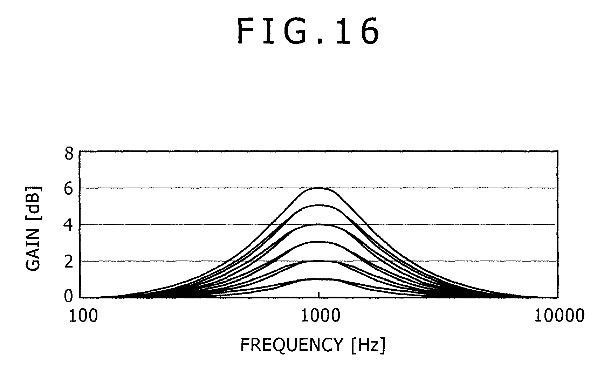

A discussion about gains will be made below with reference to Figs. 15 and 16.

Fig. 15A shows correction characteristics (gain sequences) corresponding to various gains when the center frequency is 1 kHz and the Q value is 1.0.

Fig. 15B shows gain sequences when the center frequency is 1 kHz and the Q value is 1.0 as with the gain sequences of Fig. 15A. However, the gain sequences other than the gain sequence corresponding to the largest peak gain gp (= 6.0 dB) are obtained through calculation. Specifically, the gains of the gain sequence corresponding to the peak gain gt (other than 6.0 dB) are obtained by multiplying the gains of the gain sequence corresponding to the largest peak gain gp by gt/gp.

Fig. 16 is a diagram resulting from superposition of Fig. 15A on Fig. 15B. As shown in Fig. 16, the approximate gain sequences of Fig. 15B arising from the multiplication by gt/gp are very close to the ideal gain sequences of Fig. 15A although there are partial small differences therebetween.

Therefore, there is no need to store in a correction characteristic table a gain sequence as a correction characteristic for each of a large number of gains. It is sufficient that only a gain sequence corresponding to one gain is stored and correction characteristics for other gains are obtained through calculation with the coefficient gt/gp.

As described above, the following three schemes for a correction characteristic table are effective for reduction in the data amount of the correction characteristic table: only the data of a gain sequence corresponding to one representative center frequency is stored; only gains on one side from a peak gain along the frequency axis direction are stored as the data of a gain sequence; and only the data of a gain sequence corresponding to one representative gain is stored.

Only one of these three schemes may be employed. Alternatively, two or all of the schemes may be employed.

For example, if all the three schemes are employed for the correction characteristic table of Fig. 10, only the data expressed by white characters (reverse printing) are necessary. Specifically, for each Q-value candidate, a frequency of 900 Hz is defined as the representative center frequency fc, and a gain of + 3dB is defined as the representative gain. Furthermore, as the data of a gain sequence, only gains at frequencies 100 Hz, 300 Hz, and 900 Hz are stored as the data on one side along the frequency axis direction.

As a result, the data amount of the correction characteristic table can be significantly reduced.

Thus, the above-described data amount reduction method can be applied for a correction characteristic table depending on the performance and burden of the capacity of the audio reproduction device 1.

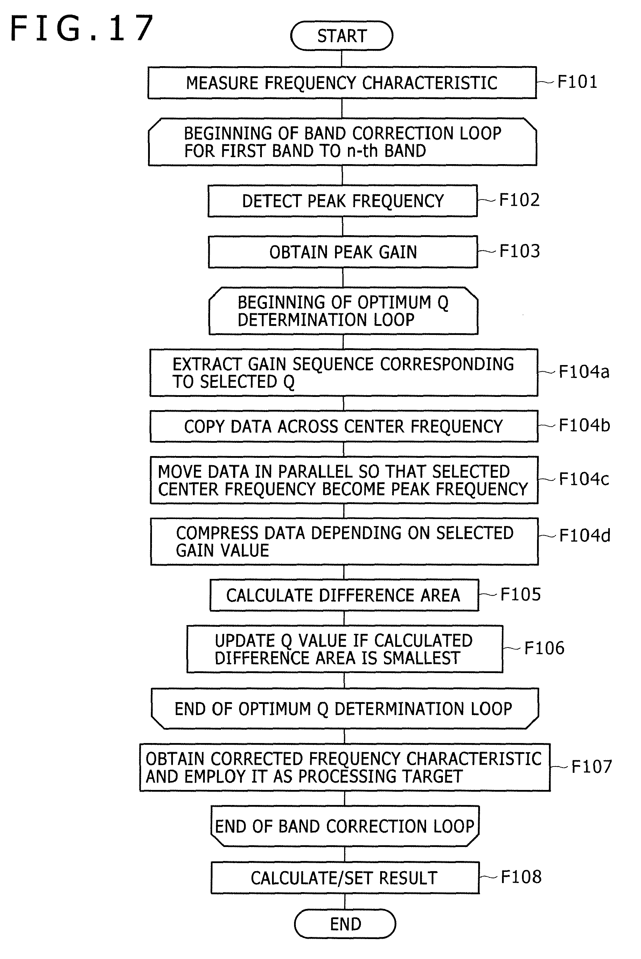

Fig. 17 shows processing for parameter calculation when the above-described three schemes are employed.

The processing of Fig. 17 is basically the same as that of Fig. 12, except that steps F104a to F104d are carried out in the processing of Fig. 17 instead of the step F104 in Fig. 12 for retrieving a correction characteristic from a correction characteristic table. The other steps in Fig. 17 are given the same step numerals as those in Fig. 12, i.e., F101 to F103 and F105 to F108, and redundant overlapping description is omitted.

After the determination of the center frequency fc and gain, the arithmetic unit 21 executes processing of the steps F104a to F106 for each Q-value candidate in order to determine the optimum Q value. Initially in the step F104a, a gain sequence is retrieved from a correction characteristic table for the selected Q value, i.e., the Q value for which the difference area is to be obtained, of all the Q-value candidates. If the correction characteristic table holds only the data expressed by white characters for the Q values Q0, Q1 and Q2 as shown in Fig. 10, and initially processing for the Q value Q0 is to be executed, the gain sequence stored for the Q value Q0 (0.05 dB, 0.51 dB, 3 dB) is retrieved.

Subsequently, in the step F104b, the data of the gain sequence is copied across the center frequency. Because the gains 0.05 dB, 0.51 dB, and 3 dB correspond to a gain sequence on one side (lower frequency side) from the peak gain (3 dB) on the frequency axis, a gain sequence on the other side (higher frequency side) is created. Thus, a gain sequence formed of gains 0.05 dB, 0.51 dB, 3 dB, 0.51 dB, and 0.05 dB is created.

In the step F104c, the data is moved in parallel to the frequency axis direction so that the frequency offering the peak gain may become the center frequency fc determined as a parameter. In the case of the gain sequence 0.05 dB, 0.51 dB, 3 dB, 0.51 dB, and 0.05 dB, the data is moved so that the frequency corresponding to the peak gain 3 dB may become the center frequency fc determined in the step F102.

In the step F104d, the gains 0.05 dB, 0.51 dB, 3 dB, 0.51 dB, and 0.05 dB are compressed depending on the gain determined as a parameter. If the determined gain is 1 dB, the respective values are compressed to 1/3 values.

The result of the step F104d is used as the correction characteristic for the determined center frequency fc and gain, and the selected Q value of all the Q-value candidates. After the step F104d, the processing of the steps F105 and F106 is executed with use of this correction characteristic, so that the difference area for the selected Q value is obtained.

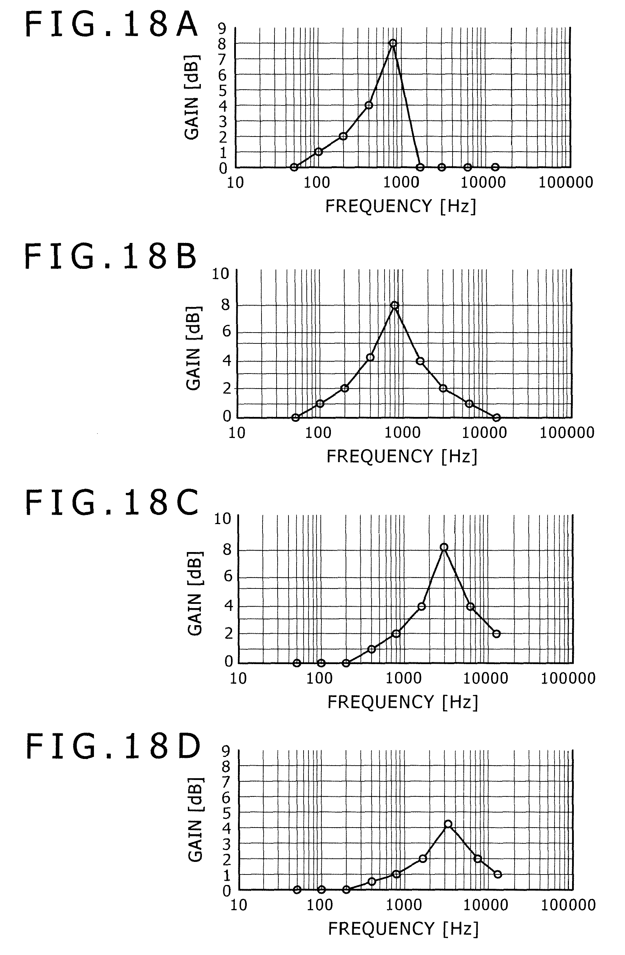

Fig. 18 shows images of the processing for obtaining a correction characteristic (gain sequence) in the steps F104a to F104d. In the example of Fig. 18, the number of frequency points forming a gain sequence is nine (i.e., 50 Hz, 100 Hz, 200 Hz, 400 Hz, 800 Hz, 1.6 kHz, 3.2 kHz, 6.4 kHz, and 12.8 kHz), and the peak gain is 8 dB.

This example is based on an assumption that the gains at frequencies 50 Hz, 100 Hz, 200 Hz, 400 Hz, and 800 Hz are stored in a correction characteristic table.

In the step F104a, as shown in Fig. 18A, a gain sequence on one side (lower frequency side) from the peak gain along the frequency axis direction is retrieved from the correction characteristic table.

In the step F104b, as shown in Fig. 18B, a gain sequence on the higher frequency side from the peak gain is created through copying of the gains on the lower frequency side.

In the step F104c, as shown in Fig. 18C, the gain sequence pattern is moved in parallel to the frequency axis direction. The operation of Fig. 18C corresponds to the case where the center frequency fc is determined as 3.2 kHz. Therefore, by this operation, the pattern is moved in parallel so that the gain at the frequency 3.2 kHz may become the peak gain 8 dB.

In the step F104d, the respective gains of the gain sequence are compressed. If the center frequency fc and gain have been determined as 3.2 kHz and 4 dB, respectively, the above-described coefficient gt/gp is 1/2. Therefore, as shown in Fig. 18D, the respective values shown in Fig. 18C are compressed to the 1/2 values. The resultant gain sequence of Fig. 18D is equivalent to the correction characteristic for the determined center frequency fc and gain, and the currently-processed Q value.

As is apparent from this example, if one Q value is determined, gain sequences for various center frequencies and gains can be created approximately. Accordingly, it is sufficient for a correction characteristic table to hold the same number of gain sequences as the number of Q-value candidates, and hence great reduction in the usage and processing amount of a memory can be realized.

This is the end of the description of the embodiment. Embodiments of the present invention can be applied as an equalizer parameter calculation method for various audio apparatuses and audio systems.

In the above-described example, parameters are calculated for sound field adjustment so that reproduction of audio collected through the microphone 2 may be based on the target frequency characteristic S2. However, embodiments of the present invention can be applied also to setting of parameters of an equalizer for any other target frequency characteristic.

It should be understood by those skilled in the art that various modifications, combinations, subcombinations and alterations may occur depending on design requirements and other factor in so far as they are within the scope of the appended claims or the equivalents thereof.

**Claims**

1. An audio output device comprising:

    an equalizer configured to execute frequency characteristic correction processing for an audio signal from an audio source;
    an output part configured to supply an audio signal processed by the equalizer to a speaker for audio output from the speaker;
    a signal analyzer configured to analyze a frequency characteristic of an input audio signal to thereby obtain a gain of each of sample points on a frequency axis; and
    an arithmetic unit configured to control parameters of the equalizer, the arithmetic unit extracting sample points having substantially equal intervals on a logarithmic-scale frequency axis from sample points of which gains have been obtained by the signal analyzer, the arithmetic unit calculating parameters of the equalizer by using differences between gains of the extracted sample points and gains at frequencies corresponding to the extracted sample points on a target frequency characteristic.

2. The audio output device according to claim 1, further comprising
   a measurement signal generator configured to generate a measurement audio signal, wherein
   the signal analyzer analyzes a frequency characteristic of an input audio signal collected through a microphone, upon output of a measurement audio signal generated by the measurement signal generator from the speaker by the output part.

3. The audio output device according to claim 1, wherein
the equalizer is a parametric equalizer.

4. The audio output device according to claim 1, wherein
the arithmetic unit calculates a center frequency, a gain, and sharpness for frequency characteristic correction processing as parameters of the equalizer.

5. The audio output device according to claim 4, wherein
the arithmetic unit executes center frequency determination processing for determining, as a center frequency as a parameter of the equalizer, a frequency of a sample point that offers a largest gain difference with respect to a target frequency characteristic among sample points having substantially equal intervals on a logarithmic-scale frequency axis,
the arithmetic unit executes gain determination processing for determining, as a gain as a parameter of the equalizer, a gain difference of the sample point of which frequency has been determined as the center frequency,
the arithmetic unit executes sharpness determination processing for calculating difference areas between a target frequency characteristic and corrected frequency characteristics each corresponding to the determined center frequency, the determined gain, and a respective one of a plurality of sharpness candidates, and determining sharpness offering a smallest difference area as sharpness as a parameter of the equalizer, and
the difference area in the sharpness determination processing is obtained as a sum of differences in a gain between sample points having subsequently equal intervals on a logarithmic-scale frequency axis and corresponding frequency points on a target frequency characteristic.

6. The audio output device according to claim 5, wherein
the equalizer executes frequency characteristic correction processing for n bands, and
the arithmetic unit executes the center frequency determination processing, the gain determination processing, and the sharpness determination processing for each of the n bands to thereby calculate parameters as a center frequency, a gain, and sharpness for each of the n bands, and in calculation of parameters for a X-th (X is 2 to n) band, the arithmetic unit executes the center frequency determination processing, the gain determination processing, and the sharpness determination processing by using a frequency characteristic resulting from correction based on parameter calculation results for bands from a first band to a (X - 1)-th band.

7. The audio output device according to claim 5, further comprising
a correction characteristic table configured to store therein gain sequences as correction characteristics based on a center frequency and a gain for a plurality of sharpness candidates, wherein
in the sharpness determination processing, the difference area is calculated by using a correction characteristic retrieved from the correction characteristic table for each of the sharpness candidates.

8. The audio output device according to claim 7, wherein
correction characteristics corresponding to a specific center frequency are stored in the correction characteristic table, and
in the sharpness determination processing, a correction characteristic corresponding to a center frequency determined in the center frequency determination processing is calculated by using a correction characteristic retrieved from the correction characteristic table.

9. The audio output device according to claim 7, wherein
correction characteristics corresponding to a specific gain are stored in the correction characteristic table, and
in the sharpness determination processing, a correction characteristic corresponding to a gain determined in the gain determination processing is calculated by using a correction characteristic retrieved from the correction characteristic table.

10. A method for calculating parameters of an equalizer for correcting a frequency characteristic of an audio signal to a target frequency characteristic, the method comprising the steps of:

(a) analyzing a frequency characteristic of an input audio signal to thereby obtain a gain of each of sample points on a frequency axis; and

(b) extracting sample points having substantially equal intervals on a logarithmic-scale frequency axis from the sample points of which gains have been obtained in the step (a), and calculating the parameters of the equalizer by using differences between gains of the extracted sample points and gains at frequencies corresponding to the extracted sample points on the target frequency characteristic.

11. The method for calculating parameters according to claim 10, wherein
the step (b) includes center frequency determination processing for determining, as a center frequency as the parameter of the equalizer, a frequency of a sample point that offers a largest gain difference with respect to the target frequency characteristic among the sample points having substantially equal intervals on a logarithmic-scale frequency axis,
the step (b) includes gain determination processing for determining, as a gain as the parameter of the equalizer, a gain difference of the sample point of which frequency has been determined as the center frequency,
the step (b) includes sharpness determination processing for calculating difference areas between the target frequency characteristic and corrected frequency characteristics each corresponding to the determined center frequency, the determined gain, and a respective one of a plurality of sharpness candidates, and determining sharpness offering a smallest difference area as sharpness as the parameter of the equalizer, and
the difference area in the sharpness determination processing is obtained as a sum of differences in a gain between the sample points having subsequently equal intervals on a logarithmic-scale frequency axis and corresponding frequency points on the target frequency characteristic.

# FIG.1

EP 1 848 110 A2

# FIG.2A

# FIG.2B

# FIG.2C

# FIG.3A

# FIG.3B

# FIG.3C

# FIG.4A

# FIG.4B

# FIG.4C

# FIG.5A

# FIG.5B

# FIG.5C

# FIG.6A

# FIG.6B

# FIG.6C

FIG.7A

FIG.7B

# F I G . 8

# F I G . 9

# FIG.10

Qid=Q0

| Q=1.0 | | | | | | | | | | | | | | |
|---|---|---|---|---|---|---|---|---|---|---|---|---|---|---|
| Fc | 100 | | | 300 | | | 900 | | | 2.7k | | | 8.1k | | |
| Band[Hz] | +3 | +2 | +1 | +3 | +2 | +1 | +3 | +2 | +1 | +3 | +2 | +1 | +3 | +2 | +1 |
| 100 | 2.99 | 1.99 | 1 | 0.47 | 0.28 | 0.13 | 0.05 | 0.03 | 0.01 | 0.01 | 0 | 0 | 0 | 0 | 0 |
| 300 | 0.5 | 0.3 | 0.14 | 3 | 2 | 1 | 0.51 | 0.31 | 0.14 | 0.06 | 0.03 | 0.01 | 0.01 | 0.01 | 0 |
| 900 | 0.05 | 0.03 | 0.01 | 0.5 | 0.3 | 0.13 | 3 | 2 | 1 | 0.53 | 0.32 | 0.14 | 0.09 | 0.05 | 0.02 |
| 2.7k | 0.01 | 0 | 0 | 0.05 | 0.03 | 0.01 | 0.49 | 0.3 | 0.13 | 3 | 2 | 1 | 0.72 | 0.43 | 0.2 |
| 8.1k | 0 | 0 | 0 | 0 | 0 | 0 | 0.04 | 0.03 | 0.01 | 0.43 | 0.26 | 0.12 | 3 | 2 | 1 |

Qid=Q1

| Q=2.0 | | | | | | | | | | | | | | |
|---|---|---|---|---|---|---|---|---|---|---|---|---|---|---|
| Fc | 100 | | | 300 | | | 900 | | | 2.7k | | | 8.1k | | |
| Band[Hz] | +3 | +2 | +1 | +3 | +2 | +1 | +3 | +2 | +1 | +3 | +2 | +1 | +3 | +2 | +1 |
| 100 | 2.97 | 1.97 | 0.99 | 0.13 | 0.08 | 0.04 | 0.01 | 0.01 | 0 | 0 | 0 | 0 | 0 | 0 | 0 |
| 300 | 0.14 | 0.08 | 0.04 | 3 | 2 | 1 | 0.15 | 0.09 | 0.04 | 0.01 | 0.01 | 0 | 0 | 0 | 0 |
| 900 | 0.01 | 0.01 | 0 | 0.14 | 0.08 | 0.04 | 3 | 2 | 1 | 0.15 | 0.09 | 0.04 | 0.02 | 0.01 | 0 |
| 2.7k | 0 | 0 | 0 | 0.01 | 0.01 | 0 | 0.14 | 0.08 | 0.04 | 3 | 2 | 1 | 0.18 | 0.11 | 0.05 |
| 8.1k | 0 | 0 | 0 | 0 | 0 | 0 | 0.01 | 0.01 | 0 | 0.12 | 0.07 | 0.03 | 3 | 2 | 1 |

Qid=Q2

| Q=4.0 | | | | | | | | | | | | | | |
|---|---|---|---|---|---|---|---|---|---|---|---|---|---|---|
| Fc | 100 | | | 300 | | | 900 | | | 2.7k | | | 8.1k | | |
| Band[Hz] | +3 | +2 | +1 | +3 | +2 | +1 | +3 | +2 | +1 | +3 | +2 | +1 | +3 | +2 | +1 |
| 100 | 2.87 | 1.9 | 0.95 | 0.03 | 0.02 | 0.01 | 0 | 0 | 0 | 0 | 0 | 0 | 0 | 0 | 0 |
| 300 | 0.04 | 0.02 | 0.01 | 3 | 2 | 1 | 0.04 | 0.02 | 0.01 | 0 | 0 | 0 | 0 | 0 | 0 |
| 900 | 0 | 0 | 0 | 0.04 | 0.02 | 0.01 | 3 | 2 | 1 | 0.04 | 0.02 | 0.01 | 0 | 0 | 0 |
| 2.7k | 0 | 0 | 0 | 0 | 0 | 0 | 0.04 | 0.02 | 0.01 | 3 | 2 | 1 | 0.05 | 0.03 | 0.01 |
| 8.1k | 0 | 0 | 0 | 0 | 0 | 0 | 0 | 0 | 0 | 0.03 | 0.02 | 0.01 | 3 | 2 | 1 |

EP 1 848 110 A2

# FIG.11

# FIG.12

START

MEASURE FREQUENCY CHARACTERISTIC ~F101

BEGINNING OF BAND CORRECTION LOOP FOR FIRST BAND TO n-th BAND

DETECT PEAK FREQUENCY ~F102

OBTAIN PEAK GAIN ~F103

BEGINNING OF OPTIMUM Q DETERMINATION LOOP

OBTAIN CORRECTION CHARACTERISTIC ~F104

CALCULATE DIFFERENCE AREA ~F105

UPDATE Q VALUE IF CALCULATED DIFFERENCE AREA IS SMALLEST ~F106

END OF OPTIMUM Q DETERMINATION LOOP

OBTAIN CORRECTED FREQUENCY CHARACTERISTIC AND EMPLOY IT AS PROCESSING TARGET ~F107

END OF BAND CORRECTION LOOP

CALCULATE/SET RESULT ~F108

END

# FIG.13A    FIG.13B    FIG.13C

| 10 | 100 | 1k | 10k |

| 10 | 100 | 1k | 10k |

| 10 | 100 | 1k | 10k |

EP 1 848 110 A2

# FIG.14A

# FIG.14B

# FIG.14C

10  100  1k  10k

10  100  1k  10k

10  100  1k  10k

EP 1 848 110 A2

# FIG.15A

GAIN [dB]

FREQUENCY [Hz]

# FIG.15B

GAIN [dB]

FREQUENCY [Hz]

# FIG.16

# FIG.17

START

MEASURE FREQUENCY CHARACTERISTIC — F101

BEGINNING OF BAND CORRECTION LOOP
FOR FIRST BAND TO n-th BAND

DETECT PEAK FREQUENCY — F102

OBTAIN PEAK GAIN — F103

BEGINNING OF OPTIMUM Q
DETERMINATION LOOP

EXTRACT GAIN SEQUENCE CORRESPONDING
TO SELECTED Q — F104a

COPY DATA ACROSS CENTER FREQUENCY — F104b

MOVE DATA IN PARALLEL SO THAT SELECTED
CENTER FREQUENCY BECOME PEAK FREQUENCY — F104c

COMPRESS DATA DEPENDING ON SELECTED
GAIN VALUE — F104d

CALCULATE DIFFERENCE AREA — F105

UPDATE Q VALUE IF CALCULATED
DIFFERENCE AREA IS SMALLEST — F106

END OF OPTIMUM Q DETERMINATION LOOP

OBTAIN CORRECTED FREQUENCY CHARACTERISTIC
AND EMPLOY IT AS PROCESSING TARGET — F107

END OF BAND CORRECTION LOOP

CALCULATE/SET RESULT — F108

END

FIG.18A

FIG.18B

FIG.18C

FIG.18D

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2006112936 A
- JP 2004297732 A
- JP 2001224100 A
- JP 2001217665 A
- JP 60051014 A
- JP 2000216664 A
- JP 3102796 B